# EUROPEAN PATENT APPLICATION

(11) **EP 1 930 739 A2**
(43) Date of publication of application: **11.06.2008**
(21) Application number: 07021715.3
(22) Date of filing: 08.11.2007
(51) Int. Cl.: G01R 33/09

(54) **Magnetic detector and method for making the same**

(30) Priority: 29.11.2006 JP 2006321657
(71) Applicant: ALPS ELECTRIC CO., LTD., Tokyo 145-8501 (JP)
(72) Inventor: Kurata, Koji, Tokyo 145-8501 (JP); Tokunaga, Ichiro, Tokyo 145-8501 (JP)
(74) Representative: Klunker . Schmitt-Nilson . Hirsch

(57) **Abstract**

A magnetic detector includes a magnetoresistive element (10) and a fixed resistor (20) that are constituted from identical laminates. Hard bias layers (17,18) are disposed on two sides of the fixed resistor (20) each with a gap therebetween. The magnetoresistive element (10) includes a magnetic layer, magnetization direction of which is variable; the fixed resistor (20) includes a magnetic layer corresponding to the magnetic layer of the magnetoresistive element (10); and the magnetization direction of the magnetic layer of the fixed resistor is pinned by a bias magnetic field from the hard bias layers (17,18).

## Description

### CLAIM OF PRIORITY

This application claims benefit of the Japanese Patent Application No. 2006-321657 filed on November 29, 2006, which is hereby incorporated by reference.

### BACKGROUND OF THE INVENTION

### 1. Field of the Invention

The present invention relates to a non-contact magnetic detector incorporating a fixed resistor and a magnetoresistive element, and a method for making the non-contact magnetic detector.

### 2. Description of the Related Art

A giant magnetoresistive (GMR) element used in magnetic sensors has a basic layer configuration including an antiferromagnetic layer, a pinned magnetic layer, a nonmagnetic material layer, and a free magnetic layer. The pinned magnetic layer is in contact with the antiferromagnetic layer, and the pinned magnetic layer has its magnetization pinned in one direction by the exchange coupling magnetic field (Hex) generated between the pinned magnetic layer and the antiferromagnetic layer. The free magnetic layer is disposed at a position that opposes the pinned magnetic layer with the nonmagnetic material layer therebetween. The magnetization direction of the free magnetic layer is not pinned and changes in response to external magnetic fields. This change in relationship between the magnetization direction of the free magnetic layer and the magnetization direction of the pinned magnetic layer allows electrical resistance to correspondingly change.

A magnetic sensor incorporating a GMR element is of a non-contact type. Moreover, since the magnetization direction of the GMR element adequately changes in response to relatively weak external magnetic fields, the magnetic sensor can be expected to achieve high performance and long lifetime.

The magnetic sensor includes the GMR element described above and a fixed resistor connected in series with the GMR element. The fixed resistor is used as a reference resistor.

In the case where the fixed resistor is formed as a single layer composed of a high-resistance material, it is possible to adjust the fixed resistor to exhibit the same resistance R as the GMR element. However, in such a case, the temperature coefficient of resistance (TCR) of the fixed resistor becomes different from that of the GMR element having a multilayer structure including a magnetic material and a nonmagnetic material. The value of TCR becomes different if a different material is used of if the same material is used with a different thickness.

In the existing technology, in order to match the resistance R and TCR of the fixed resistor to those of the GMR element, the fixed resistors has been constituted from layers composed of the same materials as those of the GMR element while changing the order of stacking these layers to prevent the electrical resistance from changing in response to an external magnetic field.

As discussed above, the basic layer configuration of the magnetoresistive element includes an antiferromagnetic layer, a pinned magnetic layer, a nonmagnetic material layer, and a free magnetic layer. If the order of stacking is changed to interchange the positions of the nonmagnetic material layer and the free magnetic layer so that the free magnetic layer is in contact with the pinned magnetic layer, the magnetization direction of the free magnetic layer becomes pinned as with the pinned magnetic layer, and the free magnetic layer can no longer function as a free magnetic layer.

In the case where a fixed resistor is to be formed by changing the order of stacking layers from that of the magnetoresistive element as described above, however, the fixed resistor and the magnetoresistive element cannot be made in the same process. In other words, since the configuration of the multilayer structure of the magnetoresistive element is different from that of the fixed resistor, they cannot be made in the same process. For example, the fixed resistor must be made by a separate process after the magnetoresistive element is made. Due to this, the thickness of each layer varies between the fixed resistor and the magnetoresistive element, and it has been difficult to form a fixed resistor having the same resistance R and TCR as those of the magnetoresistive element.

The variation in resistance R and TCR between the magnetoresistive element and the fixed resistor causes a problem such as variation in midpoint potential between the magnetoresistive element and the fixed resistor connected in series.

Japanese Unexamined Patent Application Publication No. 2000-174358 (referred to as '358 document hereinafter) teaches that the change in resistance can be prevented by forming a first GMR element and a second GMR element using GMR patterns having the same temperature characteristic and then heating the second GMR element at 300°C or more.

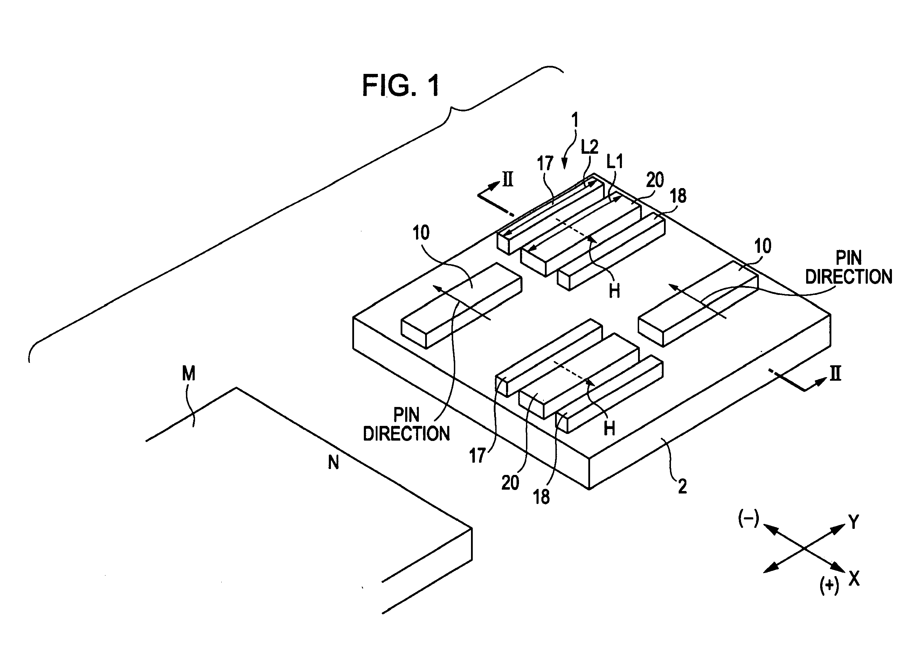

As shown in Fig. 1 of '358 document, the first GMR element 12 is disposed inside a region 100 in which the magnetic field changes, and the second GMR element 14 is disposed in the region in which the magnetic field does not change. Although the first GMR element 12 is formed on a substrate different from the substrate on which the second GMR element 14 is formed, the GMR elements 12 and 14 are initially formed on the same wafer 20, and a region 22 in which the second GMR element 14 is formed is locally heated at 300°C or more prior to dicing (refer to paragraph [0016] in '358 document).

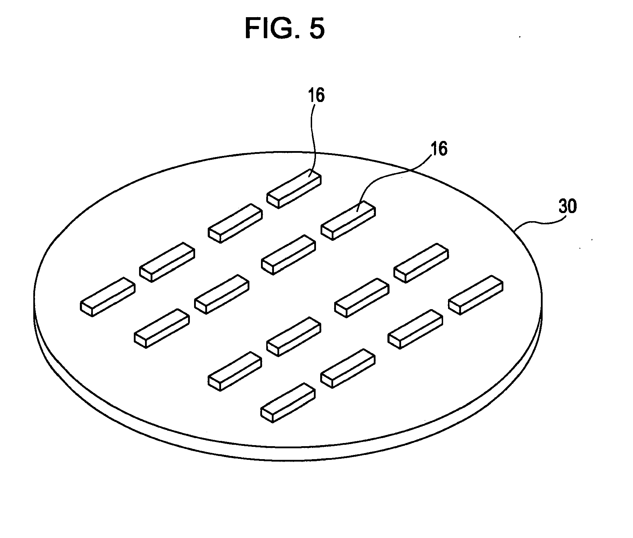

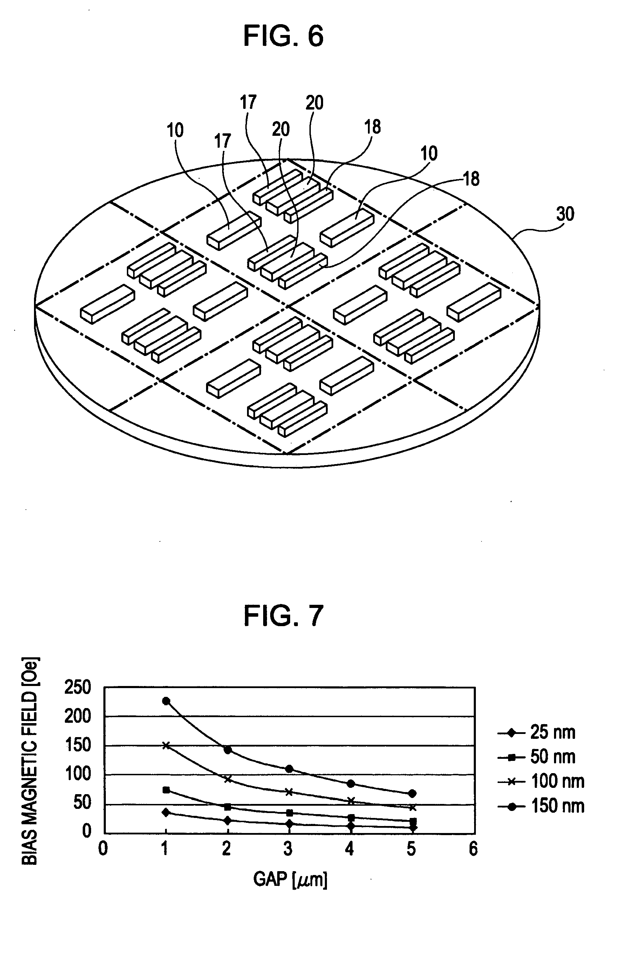

Figs. 5 and 6 of '358 document disclose embodiments in which the first GMR element 12 and the second GMR element 14 are formed on the same chip.

According to the invention disclosed in '358 document, local heating is conducted on the second GMR element 14 so that interdiffusion of the metal atoms in the ferromagnetic layer and the nonmagnetic layer of the second GMR element 14 occurs at the interface, resulting in a significant decrease in rate of change in resistance (refer to paragraph [0016] in '358 document).

However, according to the technique disclosed in '358 document, it is still possible that heating of the second GMR element 14 at 300°C or more conducted to induce interdiffusion of elements at the interface will cause the resistance R and TCR of the second GMR element 14 to change more easily when compared with the initial state before the heating. Thus, it is possible that variation in resistance R and TCR more easily occurs between the first GMR element 12 and the second GMR element 14.

Moreover, the invention disclosed in '358 document also has a problem in that the heat applied to the second GMR element 14 also affects the first GMR element 12 adjacent to the second GMR element 14, thereby affecting the magnetic characteristics of the first GMR element 12.

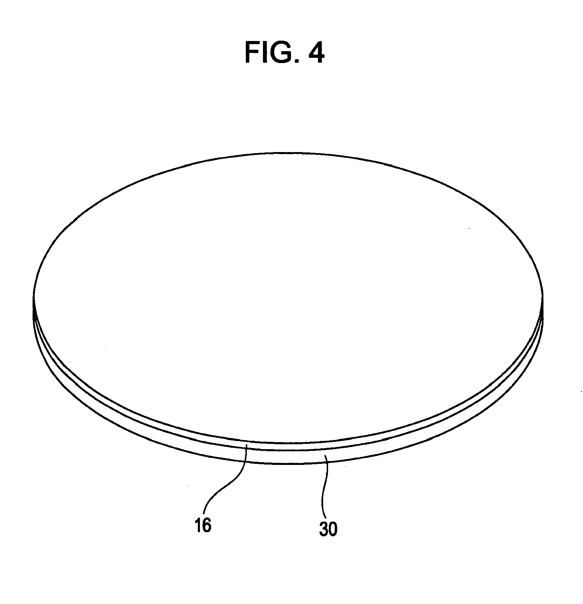

Fig. 4 of '358 document discloses an embodiment in which an electrode is formed on each of the ends of GMR patterns R1 to R4 and in which the GMR patterns R2 and R4 are heated to 300°C or more by applying electrical current.

However, producing a Joule heat of 300°C or more requires significantly large electrical current. There is also a problem in that the magnetic characteristics of the adjacent GMR patterns R1 and R3 will change by the Joule heat.

### SUMMARY OF THE INVENTION

The present invention provides a magnetic detector in which the resistance and the temperature coefficient of resistance of the fixed resistor can be easily and adequately adjusted to be equal to those of the magnetoresistive element.

A magnetic detector according to a first aspect of the present invention includes at least one magnetoresistive element having electrical resistance changing in response to an external magnetic field by a magnetoresistive effect; at least one fixed resistor having electrical resistance that does not change in response to the external magnetic field, the fixed resistor being connected to the magnetoresistive element in series; at least one hard bias layer opposing a side surface of the fixed resistor with a gap therebetween; and a substrate on which the magnetoresistive element, the fixed resistor, and the hard bias layer are disposed. The magnetoresistive element is constituted from a first laminate, the fixed resistor is constituted from a second laminate, and the first laminate is identical to the second laminate. Furthermore, the magnetoresistive element includes a magnetic layer, magnetization direction of which is variable; the fixed resistor includes a magnetic layer corresponding to the magnetic layer of the magnetoresistive element; and a magnetization direction of the magnetic layer of the fixed resistor is pinned by a bias magnetic field from the hard bias layer.

As described above, the fixed resistor and the magnetoresistive element are formed on the same substrate and are constituted from the identical laminates. The magnetization direction of the magnetic layer of the fixed resistor is pinned by the bias magnetic field from the hard bias layer; however, there is a gap between the fixed resistor and the hard bias layer. Thus, the resistance and the temperature coefficient of resistance of the fixed resistor constituted from the same laminate as the magnetoresistive element are not affected by the hard bias layer. Accordingly, when compared to the related art in which the order of stacking layers is changed between the magnetoresistive element and the fixed resistor or in which the fixed resistor is heated, the fixed resistor can maintain the same lamination state as the magnetoresistive element according to the present invention. Thus, the resistance R and the temperature coefficient of resistance (TCR) of the fixed resistor can be easily and adequately adjusted to be equal to the resistance R and the TCR of the magnetoresistive element. As a result, the potential between the magnetoresistive element and the fixed resistor connected in series can be adjusted to a midpoint potential. Moreover, since the magnetoresistive element and the fixed resistor can be formed on the same substrate, size reduction of the magnetic detector can be achieved.

The gap between the magnetoresistive element and the hard bias layer is preferably larger than the gap between the fixed resistor and the hard bias layer. In this manner, the effect of the bias magnetic field reaching the magnetization variable layer of the magnetoresistive element can be decreased by a simple technique, or the effect of the bias magnetic field can be eliminated. Thus, the magnetic layer of the magnetoresistive element can adequately function as a layer that changes magnetization in response to the external magnetic field.

Preferably, the first laminate includes a laminated portion that includes a first magnetic layer, a second magnetic layer, and a nonmagnetic material layer interposed between the first magnetic layer and the second magnetic layer; the second laminate includes a laminated portion that includes a first magnetic layer, a second magnetic layer, and a nonmagnetic material layer interposed between the first magnetic layer and the second magnetic layer; a magnetization direction of the first magnetic layer of the magnetoresistive element and a magnetization direction of the first magnetic layer of the fixed resistor are pinned; the second magnetic layer of the magnetoresistive element functions as a free magnetic layer, magnetization direction of which is variable in response with the external magnetic field; and the second magnetic layer of the fixed resistor has a magnetization direction pinned by the bias magnetic field from the hard bias layer.

In a zero magnetic field state where no external magnetic field is applied, the first layer of the magnetoresistive element and the first layer of the fixed resistor are preferably magnetized in the same direction, and the second magnetic layer of the magnetoresistive element and the second magnetic layer of the fixed resistor are preferably magnetized in the same direction.

According to the above-described structure, the magnetoresistive element functions as a giant magnetoresistive (GMR) element utilizing a giant magnetoresistive effect (GMR effect). A magnetic detector having a large rate of change in resistance (ΔR/R) and excellent sensitivity and operational stability can be achieved.

The magnetic detector of the present invention may include a first resistor element and a second resistor element connected to each other in series and disposed on the substrate; and a third resistor element and a fourth resistor element connected to each other in series and disposed on the substrate. In this magnetic detector, the second resistor element and the fourth resistor element are connected in parallel to form a bridge circuit on the substrate; the first resistor element, the second resistor element, the third resistor element, and the fourth resistor element are constituted from laminates identical to one another; and the first resistor element and the fourth resistor element are the magnetoresistive elements and the second resistor element and the third resistor elements are the fixed resistors.

This bridge circuit increases sensitivity.

The gap between the fixed resistor and the hard bias layer is preferably 1 µm or more and 5 µm or less. The thickness of the hard bias layer is preferably 50 nm or more and 150 nm or less. According to this structure, a sufficient bias magnetic field can be applied to the magnetic layer of the fixed resistor corresponding to the magnetic layer of the magnetoresistive element having a variable magnetization direction, and the magnetization direction of the magnetic layer of the fixed resistor can be adequately pinned.

A second aspect of the present invention provides a method for making a magnetic detector including magnetoresistive elements having electrical resistance changing in response to an external magnetic field by a magnetoresistive effect, fixed resistors having electrical resistance that does not change in response to the external magnetic field and being connected to the magnetoresistive elements in series, and a substrate on which the magnetoresistive elements and the fixed resistors are disposed. The method includes the steps of forming a laminate layer, from which the magnetoresistive element is to be formed, over the entire surface of a wafer larger than the substrate; removing portions of the laminate layer so that a plurality of sets of the magnetoresistive element and the fixed resistor are formed, each set including at least one magnetoresistive element and at least one fixed resistor; forming hard bias layers on the substrate, each hard bias layer opposing a side surface of the fixed resistor with a gap therebetween such that a magnetic layer of the fixed resistor corresponding to a magnetization direction-variable layer of the magnetoresistive element has a magnetization direction pinned by a bias magnetic field from the hard bias layer; and dividing the wafer into independent pieces each having one of the sets.

According to this method, the magnetoresistive elements and the fixed resistors can have the same laminate structure, and the magnetization direction of the magnetic layer of the fixed resistor corresponding to the magnetic layer of the magnetoresistive element whose magnetization direction is variable can be adequately pinned. According to this invention, the resistance R and the temperature coefficient of resistance (TCR) of the fixed resistor can be easily and adequately adjusted to be equal to those of the magnetoresistive element, and a plurality of such magnetic detectors can be manufactured simultaneously. Furthermore, size reduction of the magnetic detectors can be achieved.

### BRIEF DESCRIPTION OF THE DRAWINGS

Fig. 1 is a perspective view of a magnetic detector according to an embodiment;
Fig. 2 is a cross-sectional view of the magnetic detector shown in Fig. 1 taken in the thickness direction along line II-II, as viewed from the direction of the arrow;
Fig. 3 is a circuit diagram of the magnetic detector of this embodiment;
Fig. 4 is a perspective view showing the process of making the magnetic detector of this embodiment;
Fig. 5 is a perspective view showing the step subsequent to the step shown in Fig. 4;
Fig. 6 is a perspective view showing the step subsequent to the step shown in Fig. 5; and
Fig. 7 is a graph showing the relationship between the bias magnetic field and the gap between the fixed resistor and the hard bias layers of different thicknesses.

### DESCRIPTION OF THE PREFERRED EMBODIMENTS

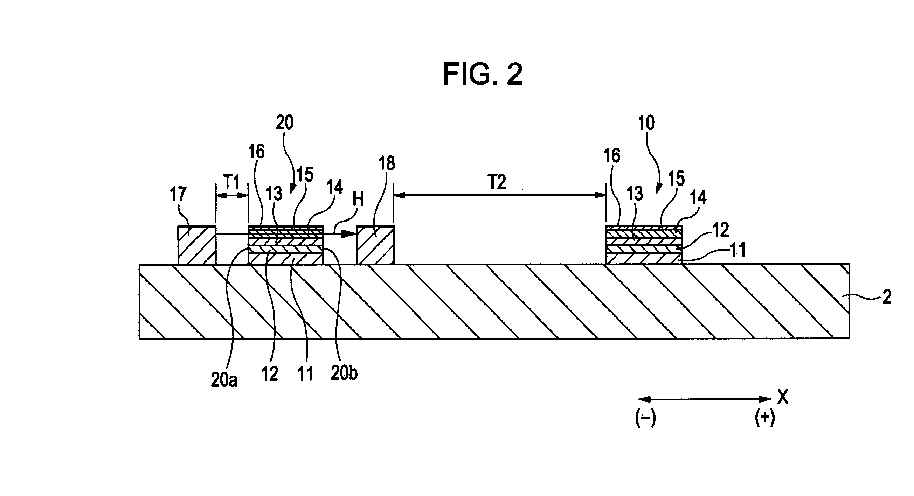

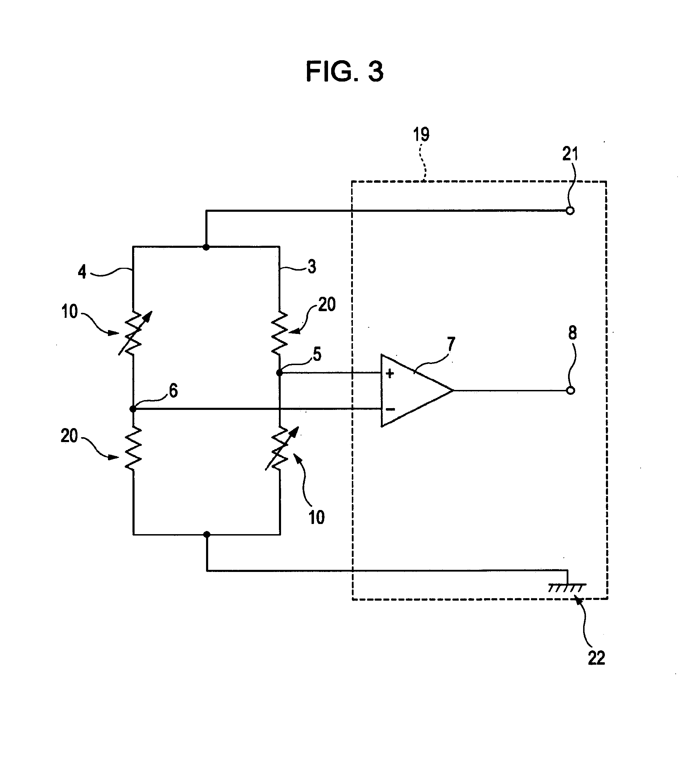

Fig. 1 is a perspective diagram of a magnetic detector according to an embodiment of the present invention. Fig. 2 is a cross-sectional view of the magnetic detector of Fig. 1 taken in a thickness direction along line II-II in Fig. 1, as viewed in the direction of the arrow. Fig. 3 is a circuit diagram of the magnetic detector of this embodiment. In the drawings, the X direction indicates the width direction, the Y direction indicates the length direction, and the X direction is orthogonal to the Y direction.

A magnetic detector 1 shown in Fig. 1 is an IC package in which magnetoresistive elements 10, fixed resistors 20, and an integrated circuit 19 (refer to Fig. 3) are integrated.

The magnetic detector 1 is not in contact with a magnetic field-generating member, a magnet M, for example. The electrical resistance of the magnetoresistive element 10 changes in response to the change in direction of the external magnetic field applied by the magnet M.

The magnetoresistive element 10 is a giant magnetoresistive (GMR) element having electrical resistance changing in response to the external magnetic field by the giant magnetoresistive effect (GMR effect). In contrast, the fixed resistor 20 has electrical resistance that does not change in response to the external magnetic field.

As shown in Figs. 1 and 2, the magnetoresistive elements 10 and the fixed resistors 20 are formed on the same substrate, i.e., a substrate 2.

As shown in Fig. 1, two magnetoresistive elements 10 and two fixed resistors 20 are provided on the substrate.

As shown in Fig. 3, the two magnetoresistive elements 10 are connected to the two fixed resistors 20, respectively, so that a first series circuit 3 and a second series circuit 4 are formed. The fixed resistor 20 (second resistor element) of the first series circuit 3 is connected in parallel to the magnetoresistive element 10 (fourth resistor element) of the second series circuit 4 via an input terminal 21. The magnetoresistive element 10 (first resistor element) of the first series circuit 3 is connected in parallel to the fixed resistor 20 (third resistor element) of the second series circuit 4 via an earth terminal 22. As a result, a bridge circuit shown in Fig. 3 is formed.

An output node 5 between the magnetoresistive element 10 of the first series circuit 3 and the fixed resistor 20 of the first series circuit 3 is connected to the input side of a differential amplifier 7. An output node 6 between the magnetoresistive element 10 of the second series circuit 4 and the fixed resistor 20 of the second series circuit 4 is also connected to the input side of the differential amplifier 7. The output side of the differential amplifier 7 is connected to an output terminal 8 via a comparator and the like not shown in the drawing.

As shown in Fig. 2, the magnetoresistive element 10 is a laminate 16 that includes, from the bottom, an antiferromagnetic layer 11, a first magnetic layer 12, a nonmagnetic material layer 13, a second magnetic layer 14, and a protective layer 15. The layer configuration of the laminate 16 is not limited to one shown in Fig. 2.

The first magnetic layer 12 is a pinned magnetic layer having magnetization firmly pinned in one direction by an exchange coupling magnetic field (Hex) generated between the first magnetic layer 12 and the antiferromagnetic layer 11. The magnetization direction of the first magnetic layer 12 is indicated as "PIN DIRECTION" in Fig. 1. The pin direction is orthogonal to the longitudinal direction (X direction in the drawing) of the magnetoresistive element 10.

The second magnetic layer 14 functions as a free magnetic layer, magnetization direction of which is not pinned. In other words, the magnetization of the second magnetic layer 14 changes in response to the external magnetic field. The external magnetic field entering the magnetoresistive element 10 in a direction parallel to the interfaces of the layers changes the magnetization direction of the second magnetic layer 14 (free magnetic layer) along the direction of the external magnetic field. This changes the relationship between the magnetization direction of the second magnetic layer (free magnetic layer) and the pinning direction of the magnetization of the first magnetic layer 12 (pinned magnetic layer) and thereby changes the electrical resistance.

The antiferromagnetic layer 11 is composed of, for example, IrMn or PtMn. The first magnetic layer 12 and the second magnetic layer 14 are each composed of, for example, CoFe or NiFe. The nonmagnetic material layer 13 is composed of, for example, copper. The protective layer 15 is composed of, for example, tantalum.

In this embodiment, as shown in Fig. 2, the fixed resistor 20 is constituted from the same laminate 16 as the magnetoresistive element 10. That is, the fixed resistor 20 is also constituted from a laminate including, from the bottom, the antiferromagnetic layer 11, the first magnetic layer 12, the nonmagnetic material layer 13, the second magnetic layer 14, and the protective layer 15. The layers of the magnetoresistive element 10 have the same thickness as the corresponding layers of the fixed resistor 20.

The fixed resistor 20 is similar to the magnetoresistive element 10 in that the first magnetic layer 12 of the fixed resistor 20 also has a magnetization direction firmly pinned in one direction by an exchange coupling magnetic field (Hex) generated between the first magnetic layer 12 and the antiferromagnetic layer 11. The magnetization direction of the first magnetic layer 12 of the fixed resistor 20 is the same as the magnetization direction of the first magnetic layer 12 of the magnetoresistive element 10.

In contrast, the second magnetic layer 14 of the fixed resistor 20 is different from the second magnetic layer 14 (free magnetic layer) of the magnetoresistive element 10 in that the magnetization direction is pinned.

In this embodiment, as shown in Figs. 1 and 2, hard bias layers 17 and 18 are respectively formed on two sides of the fixed resistor 20 in the longitudinal direction. In particular, the hard bias layer 17 faces a side surface 20a of the fixed resistor 20 with a predetermined gap T1 therebetween, and the hard bias layer 18 faces a side surface 20b of the fixed resistor 20 with a predetermined gap T1 therebetween.

The hard bias layers 17 and 18 are composed of a hard magnetic material such as CoPt, CoPtCr, or the like. A length L2 of the hard bias layers 17 and 18 in the longitudinal direction (the Y direction in the drawing) is preferably substantially equal to or slightly larger than the length L1 of the fixed resistor 20 in the longitudinal direction. In this manner, a bias magnetic field can be uniformly applied over the entirety of the fixed resistor 20.

The hard bias layers 17 and 18 disposed at the two sides of the fixed resistor 20 produce a bias magnetic field H directed to the fixed resistor 20. The bias magnetic field H pins the magnetization direction of the second magnetic layer 14 of the fixed resistor 20 in the direction of the bias magnetic field H. In Figs. 1 and 2, the bias magnetic field H is applied in the positive X direction.

In this embodiment, the magnetoresistive elements 10 and the fixed resistors 20 are disposed on the same substrate, substrate 2. According to this structure, the fixed resistors 20 lie in the region where the magnetic field from the magnet M acts. However, since the first magnetic layer 12 and the second magnetic layer 14 of the fixed resistor 20 both have pinned magnetization direction, the electrical resistance of the fixed resistor 20 does not change in response to the external magnetic field. Size reduction of the magnetic detector 1 can be promoted by providing the magnetoresistive elements 10 and the fixed resistors 20 on the same substrate 2.

As described above, the laminate 16 constituting the fixed resistor 20 is separated from the hard bias layer 18 by the predetermined gap T1. Thus, the resistance R and the temperature coefficient of resistance (TCR) of the fixed resistor 20 can be determined on the basis of the resistance and TCR of the laminate 16 only.

In this embodiment, the laminate 16 constituting the fixed resistor 20 is the same as the laminate 16 constituting the magnetoresistive element 10. Thus, compared with the related art, the resistance R and the TCR of the fixed resistor 20 can be more easily and adequately adjusted to the resistance R and the TCR of the magnetoresistive element 10. As a result, the potential between the magnetoresistive element 10 and the fixed resistor 20 connected in series (the potential at the output node 5 or 6 in Fig. 3) can be easily and adequately controlled at a midpoint potential in a zero magnetic field in which there is no action of the external magnetic field from the magnet M.

In this embodiment, the laminate 16 of the fixed resistor 20 and the laminate 16 of the magnetoresistive element 10 are made by the same production process, as described below. Thus, compared to the existing technology in which the order of stacking layers of the fixed resistor 20 is changed from the order of stacking layers of the magnetoresistive element 10, variation in the thickness between the layers of the magnetoresistive element 10 and the corresponding layers of the fixed resistor 20 can be reduced.

According to the existing technology disclosed in '358 document in which the interfacial diffusion of the elements is induced by heating at a high temperature, the laminate of the magnetoresistive element and the laminate of the fixed resistor no longer maintain the same configuration after the heating. However, this embodiment merely involves application of the bias magnetic field H onto the laminate 16 constituting the fixed resistor 20; thus, the configuration of the laminate 16 remains the same between the magnetoresistive element 10 and the fixed resistor 20. According to this embodiment, the variation in resistance and temperature coefficient of resistance between the fixed resistor 20 and the magnetoresistive element 10 can be suppressed.

As shown in Fig. 2, the gap T2 between the magnetoresistive element 10 and the hard bias layer 18 is larger than the gap T1 between the fixed resistor 20 and the hard bias layer 17 and between the fixed resistor 20 and the hard bias layer 18. This structure prevents the bias magnetic field H from entering the magnetoresistive element 10. Accordingly, in this embodiment, the magnetization of the second magnetic layer 14 (free magnetic layer) of the fixed resistor 20 can adequately change in response to the external magnetic field. In particular, the gap T2 between the magnetoresistive element 10 and the hard bias layer 18 is about 100 µm.

A magnetic shielding layer (not shown) may be provided between the magnetoresistive element 10 and the hard bias layer 18. According to this structure, the bias magnetic field H is absorbed in the magnetic shielding layer and does not reach the magnetoresistive element 10. According to this modification of providing the magnetic shielding layer, the magnetization of the second magnetic layer 14 (free magnetic layer) of the magnetoresistive element 10 is not adversely affected even when the gap T2 between the magnetoresistive element 10 and the hard bias layer 18 is smaller than T2 shown in Fig. 2. When the gap between the magnetoresistive element 10 and the hard bias layer 18 is narrowed, further miniaturization of the magnetic detector 1 is possible.

In contrast, the gap T1 between the fixed resistor 20 and the hard bias layer 17 and between the fixed resistor 20 and the hard bias layer 18 should be small. By minimizing the gap T1, an intense bias magnetic field H can be applied from the hard bias layers 17 and 18 to the second magnetic layer 14 of the fixed resistor 20, and the magnetization direction of the second magnetic layer 14 of the fixed resistor 20 can be adequately pinned.

However, when the target gap T1 is excessively small, the fixed resistor 20 can come into contact with the hard bias layers 17 and 18 depending on the accuracy of deposition for forming the hard bias layers 17 and 18, thereby resulting in failure to produce the gap T1. Thus, it is preferable to form a gap T1 of several micrometers. In particular, the experimental results of Fig. 7 show that the gap T1 is preferably in the range of 1 to 5 µm. In Fig. 7, the hard bias layers 17 and 18 are composed of CoPt. The hard bias layers 17 and 18 each have a width of 20 µm and a length of 200 µm.

As shown in Fig. 7, when the gap T1 is in the range of 1 to 5 µm, a bias magnetic field H of 50 Oe or more and preferably 100 Oe or more can be applied to the fixed resistor 20. In this manner, the magnetization direction of the second magnetic layer 14 of the fixed resistor 20 can be effectively pinned. Note that the bias magnetic field H needs to be larger than the external magnetic field from the magnet M. The intensity of the external magnetic field from the magnet M is usually about 0 to 30 Oe although this varies according to the usage. Thus, the bias magnetic field H is set to 50 Oe or more so as to pin the magnetization of the second magnetic layer 14 against the external magnetic field from the magnet M. The intensity of the external magnetic field from the magnet M can be 30 Oe or more if the thickness of the hard bias layer is increased or the gap T1 is decreased.

The experiential results in Fig. 7 also show that the thickness of the hard bias layers 17 and 18 is preferably in the range of 50 nm to 150 nm. In this manner, a bias magnetic field H of 50 Oe or more and more preferably 100 Oe or more can be applied to the fixed resistor 20.

The thickness of the fixed resistor 20 is about 30 to 40 nm, and the thickness of the second magnetic layer 14 is about 2 to 4 nm.

In this embodiment, the laminate 16 constituting the magnetoresistive element 10 is identical to the laminate 16 constituting the fixed resistor 20. The length and the width of the magnetoresistive element 10 are preferably the same as those of the fixed resistor 20 so that the production steps can be simplified. The length and the width of the device contribute to the value of resistance as a matter of course.

In the case where the length and the width of the magnetoresistive element 10 are set to be equal to those of the fixed resistor 20, the first magnetic layer 12 of the fixed resistor 20 should be magnetized in the same direction as the magnetization of the first magnetic layer 12 of the magnetoresistive element 10 in a zero magnetic field where the external magnetic field does not act. Moreover, the second magnetic layer 14 of the magnetoresistive element 10 should be magnetized in the same direction as the second magnetic layer 14 of the fixed resistor 20 in a zero magnetic field.

The magnetization relationship between the first magnetic layer 12 (pinned magnetic layer) of the magnetoresistive element 10 and the second magnetic layer 14 (free magnetic layer) of the magnetoresistive element 10 is affected by the interlayer coupling magnetic field Hin working between the first magnetic layer 12 and the second magnetic layer 14. The interlayer coupling magnetic field Hin magnetizes the first magnetic layer 12 and the second magnetic layer 14 of the magnetoresistive element 10 in a parallel manner or an antiparallel manner. In the case where the first magnetic layer 12 and the second magnetic layer 14 of the magnetoresistive element 10 are magnetized in parallel to each other, the electrical resistance is decreased. In the case where the first magnetic layer 12 and the second magnetic layer 14 of the magnetoresistive element 10 are magnetized in antiparallel to each other, the electrical resistance is increased. Thus, when the length and the width of the magnetoresistive element 10 are designed to be the same as those of the fixed resistor 20, the magnetization directions of the first magnetic layer 12 and the second magnetic layer 14 of the fixed resistor 20 are preferably set be the same as the magnetization directions of the first magnetic layer 12 and the second magnetic layer 14 of the magnetoresistive element 10 in a zero magnetic field. This is because the resistance R of the fixed resistor 20 can be adequately set to be equal to the resistance R of the magnetoresistive element 10.

The magnetoresistive element 10 shown in Fig. 2 is a GMR element utilizing the GMR effect, as discussed above. Alternatively, an anisotropic magnetoresistive (AMR) element utilizing the anisotropic magnetoresistive effect may be used as the magnetoresistive element 10. However, a GMR element is preferable since it achieves a large ratio of change in resistance (δR/R) and increased sensitivity. Alternatively, a tunneling magnetoresistive element (TMR element) having a nonmagnetic material layer 13 composed of an insulating material such as Al₂O₃ or the like can be used as a substitute of the GMR element having a nonmagnetic material layer 13 composed of a nonmagnetic conductive material.

In this embodiment, as shown in Fig. 3, the magnetoresistive elements 10 and the fixed resistors 20 form a bridge circuit. The output nodes 5 and 6 of the bridge circuit are connected to the differential amplifier 7, and the differential amplifier 7 generates a differential potential. In a zero magnetic field where the external magnetic field is not acting, the differential potential is zero since the midpoint potential is output from the output nodes 5 and 6. As the electrical resistance of the magnetoresistive element 10 changes by the external magnetic field, the differential potential changes from zero. In this embodiment, a circuit configuration including only one of the series circuits 3 and 4 can be used instead of the configuration shown in Fig. 3. However, the bridge circuit shown in Fig. 3 that produces the differential potential can achieve enhanced sensitivity since the potential can be doubled compared to the circuit configuration with only one series circuit.

As shown in Fig. 1, the magnetoresistive element 10 and the fixed resistor 20 have a rod shape. Alternatively, the magnetoresistive element 10 and the fixed resistor 20 may have a meandering shape. The length and resistance of the device can be increased with a meandering shape. As a result, the power consumption can be decreased.

In the case where the fixed resistor 20 has a meandering shape also, the hard bias layers 17 and 18 are formed on the two sides of the fixed resistor 20 with the predetermined gap T1 therebetween, as shown in Fig. 1. In this manner, the magnetization direction of the entire second magnetic layer 14 of the fixed resistor 20 having the meandering shape can be adequately pinned.

The magnetic detector 1 of this embodiment can be used as various sensors. For example, the magnetic detector 1 can be used as a motion sensor such as a fader for a mixer or a slide volume for control, or as a magnetic encoder. In the motion sensor, the magnetization direction of the second magnetic layer 14 (free magnetic layer) changes in response to the change in direction of the external magnetic field (horizontal magnetic field) entering in the direction parallel to the interfaces of the layers of the magnetoresistive element 10, and this changes the electrical resistance of the magnetoresistive element 10. The movement can then be detected on the basis of the change in voltage induced by the change in electrical resistance of the magnetoresistive element 10.

The magnetic detector 1 can also be used as a proximity switch. For example, the magnetic detector 1 of this embodiment can be used for detecting the opening and closing motions of flip phones. The opening and closing motions are detected as follows. The distance between the magnet M and the magnetic detector 1 changes as a result of the motion; thus, the intensity of the external magnetic field applied to the magnetic detector 1 changes. A magnetic detection signal (ON/OFF signal) is then generated and output on the basis of the change in electrical resistance of the magnetoresistive element 10, and the opening and closing motions are detected on the basis of the magnetic detection signal.

This embodiment includes a modification in which the hard bias layers 17 and 18 are formed only on one side of the fixed resistor 20. However, it is preferable to provide the hard bias layers 17 and 18 on two sides of the fixed resistor 20 in order to adequately apply the bias magnetic field H to the fixed resistor 20.

In Figs. 1 and 2, the magnetoresistive elements 10 and the fixed resistors 20 are formed on the same substrate 2. Alternatively, the integrated circuit 19 may be formed on the substrate 2, and the magnetoresistive elements 10 and the fixed resistors 20 may be formed on an insulating layer disposed on the integrated circuit 19 so that further size reduction is possible.

Figs. 4 to 6 are perspective views showing the steps of making the magnetic detector 1 of this embodiment. In the step shown in Fig. 4, a laminate 16 is formed, by sputtering, over the entire surface of a wafer 30 larger than the substrate 2 shown in Fig. 1. The wafer 30 is large enough to accommodate a plurality of sets of bridge circuits, each set including two magnetoresistive elements 10 and two fixed resistors 20 as shown in Fig. 1.

The laminate 16 is prepared by sequentially depositing an antiferromagnetic layer 11, a first magnetic layer 12, a nonmagnetic material layer 13, a second magnetic layer 14, and a protective layer 15 on the wafer 30 in that order as in Fig. 2.

A first resist layer (not shown) is formed by application on an upper surface of the laminate 16, followed by exposure and development, so that the first resist layer remains only on the regions where the magnetoresistive elements 10 and the fixed resistors 20 are to be formed. The uncovered portions of the laminate 16 are removed by etching, and then the remaining first resist layer is removed.

As a result, as shown in Fig. 5, a plurality of laminates 16 having a predetermined shape and constituting a plurality of sets of bridge circuits remain on the wafer 30.

The wafer is then heated under a magnetic field to generate an exchange bias magnetic field (Hex) between the first magnetic layer 12 and the antiferromagnetic layer 11 of each laminate 16 and to pin the magnetization of the first magnetic layer 12 of each laminate 16 in the same direction.

Subsequently, a second resist layer (not shown) is formed by application over the entire surface of the wafer 30 and the laminates 16, and the regions in the second resist layer where the hard bias layers 17 and 18 are to be formed are removed by exposure and development so as to form a pattern with openings.

The hard bias layers 17 and 18 are then formed in the openings of the pattern by using a hard magnetic material such as CoPt or CoPtCr. The second resist layer is then removed.

As a result, as shown in Fig. 6, the hard bias layers 17 and 18 are formed on the two sides of the fixed resistor 20 with a predetermined gap therebetween.

The hard bias layers 17 and 18 are then magnetized in the positive X direction in Fig. 1 in a magnetic field. In this manner, the hard bias layers 17 and 18 generate the bias magnetic field H to be applied to the second magnetic layer 14 of the fixed resistor 20.

The wafer 30 is diced along dotted-chain lines shown in Fig. 6 so that the wafer 30 is separated into individual pieces of magnetic detectors 1.

According to the process of making the magnetic detector 1 of this embodiment, the laminates 16 serving as the magnetoresistive elements 10 and the fixed resistors 20 can be formed by the same process shown in Figs. 4 and 5. Accordingly, the laminates 16 can have identical structures. Here, "identical structures" means that the materials of the layers, the order of stacking layers, and the thickness of the layers are the same.

In the step shown in Fig. 6, the hard bias layers 17 and 18 are formed on the two sides of the fixed resistor 20. Here, the predetermined gap T1 is formed between the fixed resistor 20 and the hard bias layer 17 and between the fixed resistor 20 and the hard bias layer 18. Moreover, the gap T2 between the hard bias layer 18 and the magnetoresistive element 10 is adjusted to be larger than T1 (refer to Fig. 2). In this manner, the laminate 16 constituting the fixed resistor 20 can maintain a state in which the electrical resistance does not change in response to the external magnetic field, and the resistance R and TCR of the fixed resistor 20 can be easily adjusted to be equal to the resistance R and TCR of the magnetoresistive element 10. Furthermore, the second magnetic layer 14 of the magnetoresistive element 10 can adequately function as a free magnetic layer having magnetization changing in response to the external magnetic field. In this embodiment, a plurality of magnetic detectors in which the resistance R and the TCR of the fixed resistor 20 are equal to the resistance R and the TCR of the magnetoresistive element 10 can be made simultaneously.

## Claims

1. A magnetic detector comprising:
at least one magnetoresistive element having electrical resistance changing in response to an external magnetic field by a magnetoresistive effect;
at least one fixed resistor having electrical resistance that does not change in response to the external magnetic field, the fixed resistor being connected to the magnetoresistive element in series;
at least one hard bias layer opposing a side surface of the fixed resistor with a gap therebetween; and
a substrate on which the magnetoresistive element, the fixed resistor, and the hard bias layer are disposed,
wherein the magnetoresistive element is constituted from a first laminate, the fixed resistor is constituted from a second laminate, and the first laminate is identical to the second laminate; and
the magnetoresistive element includes a magnetic layer, magnetization direction of which is variable, the fixed resistor includes a magnetic layer corresponding to the magnetic layer of the magnetoresistive element, and a magnetization direction of the magnetic layer of the fixed resistor is pinned by a bias magnetic field from the hard bias layer.

2. The magnetic detector according to claim 1, wherein a gap between the magnetoresistive element and the hard bias layer is larger than the gap between the fixed resistor and the hard bias layer.

3. The magnetic detector according to claim 1 or 2, wherein the first laminate includes a laminated portion that includes a first magnetic layer, a second magnetic layer, and a nonmagnetic material layer interposed between the first magnetic layer and the second magnetic layer,
the second laminate includes a laminated portion that includes a first magnetic layer, a second magnetic layer, and
a nonmagnetic material layer interposed between the first magnetic layer and the second magnetic layer;
a magnetization direction of the first magnetic layer of the magnetoresistive element and a magnetization direction of the first magnetic layer of the fixed resistor are pinned;
the second magnetic layer of the magnetoresistive element functions as a free magnetic layer, magnetization direction of which is variable in response with the external magnetic field; and
the second magnetic layer of the fixed resistor has a magnetization direction pinned by the bias magnetic field from the hard bias layer.

4. The magnetic detector according to claim 3, wherein, in a zero magnetic field state where no external magnetic field is applied, the first layer of the magnetoresistive element and the first layer of the fixed resistor are magnetized in the same direction, and the second magnetic layer of the magnetoresistive element and the second magnetic layer of the fixed resistor are magnetized in the same direction.

5. The magnetic detector according to any of claims 1 to 4, comprising:
a first resistor element and a second resistor element connected to each other in series and disposed on the substrate; and
a third resistor element and a fourth resistor element connected to each other in series and disposed on the substrate,
wherein
the second resistor element and the fourth resistor element are connected in parallel to form a bridge circuit on the substrate,
the first resistor element, the second resistor element, the third resistor element, and the fourth resistor element are constituted from laminates identical to one another, and
the first resistor element and the fourth resistor element are the magnetoresistive elements and the second resistor element and the third resistor elements are the fixed resistors.

6. The magnetic detector according to any of claims 1 to 5, wherein the gap between the fixed resistor and the hard bias layer is 1 µm or more and 5 µm or less.

7. The magnetic detector according to any of claims 1 to 6, where a thickness of the hard bias layer is 50 nm or more and 150 nm or less.

8. A method for making a magnetic detector including magnetoresistive elements having electrical resistance changing in response to an external magnetic field by a magnetoresistive effect, fixed resistors having electrical resistance that does not change in response to the external magnetic field and being connected to the magnetoresistive elements in series, and a substrate on which the magnetoresistive elements and the fixed resistors are disposed, the method comprising the steps of:
forming a laminate layer, from which the magnetoresistive element is to be formed, over the entire surface of a wafer larger than the substrate;
removing portions of the laminate layer so that a plurality of sets of the magnetoresistive element and the fixed resistor are formed, each set including at least one magnetoresistive element and at least one fixed resistor;
forming hard bias layers on the substrate, each hard bias layer opposing a side surface of the fixed resistor with a gap therebetween such that a magnetic layer of the fixed resistor corresponding to a magnetization direction-variable layer of the magnetoresistive element has a magnetization direction pinned by a bias magnetic field from the hard bias layer; and
dividing the wafer into independent pieces each having one of the sets.
